(19) Europäisches Patentamt

European Patent Office

Office européen des brevets

(11) **EP 2 104 143 B1**

(12) **FASCICULE DE BREVET EUROPEEN**

(45) Date de publication et mention
de la délivrance du brevet:
**25.01.2012  Bulletin 2012/04**

(51) Int Cl.:
***H01L 23/544*** (2006.01)

(21) Numéro de dépôt: **09155367.7**

(22) Date de dépôt: **17.03.2009**

(54) **Structure de test d'une capacité MOS et procédé de mesure d'une courbe de capacité en fonction de la tension associée**

Teststruktur eines MOS-Kondensators und Messverfahren einer Kapazitätskurve in Funktion von der entsprechenden Spannung

Structure for testing MOS capacitance and method for measuring a capacitance curve according to the associated voltage

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **21.03.2008  FR 0801576**

(43) Date de publication de la demande:
**23.09.2009  Bulletin 2009/39**

(73) Titulaire: **Commissariat à l'Énergie Atomique et aux Énergies Alternatives
75015 Paris (FR)**

(72) Inventeur: **Leroux, Charles
38360, NOYAREY (FR)**

(74) Mandataire: **Esselin, Sophie et al
Marks & Clerk France
Conseils en Propriété Industrielle
Immeuble " Visium "
22, avenue Aristide Briand
94117 Arcueil Cedex (FR)**

(56) Documents cités:
**US-A1- 2004 000 917     US-A1- 2005 090 916
US-B1- 6 549 029**

**Description**

L'invention concerne la caractérisation de filières technologiques de réalisation de dispositifs semi-conducteurs, et plus particulièrement une structure de test permettant de caractériser un empilement MOS grille/ oxyde de grille /semi-conducteur, par le relevé d'une courbe C(V) associée.

Les courbes C(V) qui donnent la capacité MOS en fonction de la tension de grille, permettent de déterminer des dimensions caractéristiques d'un empilement MOS, telles que notamment l'épaisseur de l'oxyde de grille, donnée en équivalent d'oxyde silicium, ce qui est noté EOT (*Equivalent Oxide Thickness*), et la tension de bandes plates (VFB), c'est-à-dire la tension pour laquelle les bandes de valence et de conduction dans le semi-conducteur sont plates.

Ces dimensions caractéristiques sont utilisées pour caractériser, suivre, et comparer des filières électroniques, suivant les recommandations établies par l'organisme ITRS ("*International Technology Roadmap for Semiconductors*") dans sa feuille de route. Cette feuille de route qui traduit la poursuite de la miniaturisation (loi de Moore) en générations technologiques appelées "noeuds", associe à chaque noeud des dimensions caractéristiques, qui comprennent notamment l'épaisseur d'oxyde de grille en EOT.

Dans l'invention on considère les filières technologiques les plus avancées, pour lesquelles l'EOT se situe autour du nanomètre voire moins.

Pour ces filières nanométriques, la caractérisation des empilements MOS grille/oxyde/semi-conducteur, nécessite l'obtention de courbes C(V) très précises, puis par des modélisations prenant en compte, en particulier, les effets quantiques, l'évaluation des paramètres de l'empilement (EOT, VFB,...).

Les courbes C(V) d'un empilement MOS sont habituellement obtenues au moyen d'un analyseur d'impédance du commerce, tel que par exemple l'analyseur commercialisé sous le nom Agilent 4284A, qui permet d'effectuer une mesure d'impédance complexe en régime de petit signal (superposition d'une tension petit signal à une tension continue).

Pour les filières nanométriques, ces techniques de relevé des courbes C(V) sur les structures de test classiques, ne permettent pas d'obtenir la précision et la fiabilité voulue, car les mesures d'impédance sont perturbées par de nombreux facteurs.

En effet, sur les surfaces de 100 microns par 100 microns, qui permettent d'obtenir des capacités de l'ordre de quelques centaines de picofarads ($10^{-12}$ farads), les mesures sont affectées par l'augmentation des courants de fuite à travers l'oxyde de grille, par effet tunnel. L'utilisation de surfaces de transistors MOS réduites, par exemple de l'ordre de 10 microns par 10 microns, permet de manière connue de palier ce problème de courant de fuite parasite, en réduisant les résistances d'accès, comme décrit par exemple dans la publication de C. Leroux et al "Characterization and modeling of nanometric SiO2 dielectrics" Microelectronic Engineering, Volume 72, Issues 1-4, April 2004, pages 121-124.

Ces structures de plus petites dimensions, de par leur valeur plus faible de capacités (picofarads), sont encore affectées par l'augmentation relative des capacités parasites, qu'il s'agisse des capacités parasites inhérentes à la structure de transistor MOS, ou des capacités propres à l'appareil de mesure et des capacités d'interconnexion entre la structure à tester et l'appareil de mesure.

Plus précisément, trois catégories de capacités parasites interviennent ainsi dans la mesure. Ce sont les capacités parasites induites par la structure MOS elle-même ; les capacités parasites amenées par les lignes d'interconnexion reliant la structure MOS aux plots de test sur lesquels seront placées les électrodes de l'appareil de mesure; et les capacités parasites associées à l'appareil de mesure.

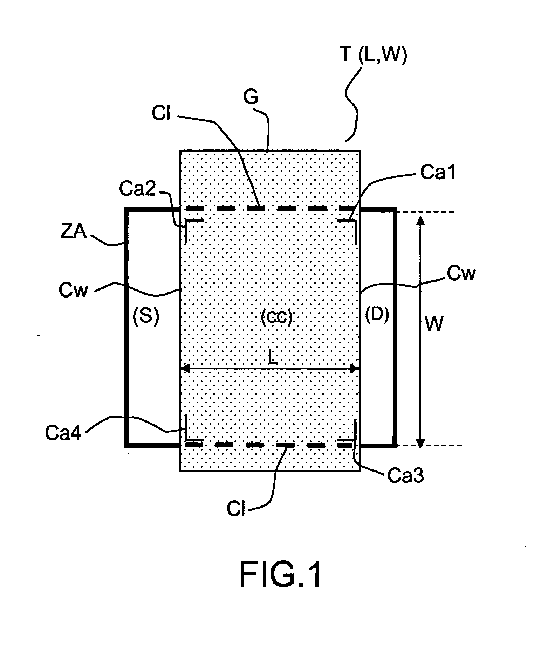

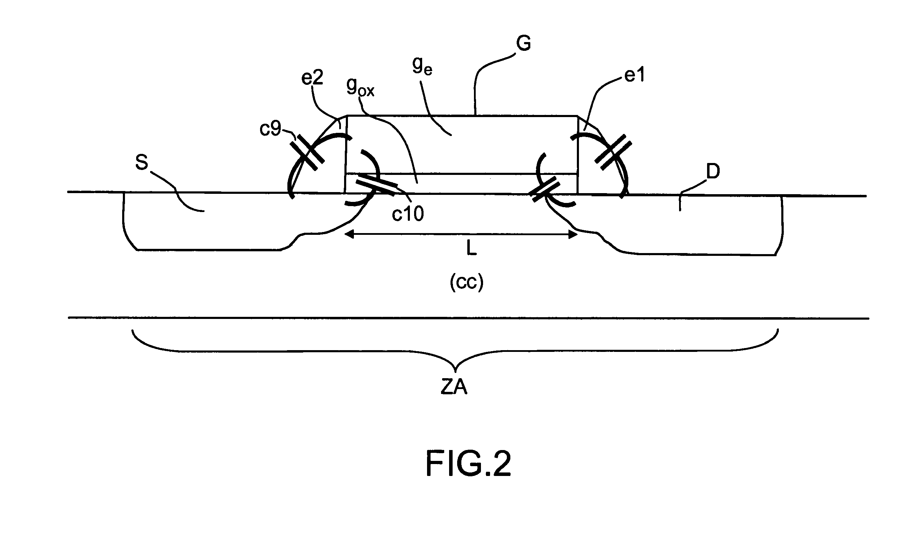

Les figures 1 et 2 illustrent les capacités parasites induites par une structure de transistor MOS. Un transistor MOS (figure 1) comprend une zone active ZA de transistor dans le substrat, sur laquelle une grille de contrôle G permet de contrôler un canal entre les zones de diffusion. Les dimensions d'un transistor sont les dimensions du canal : la longueur L du canal, c'est à dire la distance longitudinale entre les diffusions de source et drain ; et sa largeur W, est la longueur transversale du canal. Il s'agit ici des longueurs et largeurs dessinées sur les réticules, pour la fabrication des transistors. La surface du transistor est ainsi donnée par le produit L.W. La figure 2 montre les diffusions de source S et de drain D, la grille G comprenant un oxyde de grille $g_{ox}$ disposé sur le substrat sur la zone du canal cc, et l'électrode de grille $g_e$ sur l'oxyde de grille, ainsi que les espaceurs ou isolants e1, e2 habituellement prévus latéralement sur les flancs de la grille.

Les capacités parasites inhérentes à une telle structure de transistor MOS sont les capacités associées au périmètre du transistor. Ce sont de manière bien connue :

- les capacités d'angles Ca1, Ca2, Ca3, Ca4 (figure 1) de nature tridimensionnelles, à l'endroit des quatre angles correspondant aux sommets de la zone de grille G de dimensions W sur L qui surplombe la zone active ZA;
- les capacités parasites de bord de grille sur la zone active qui comprennent les capacités Cw suivant sa largeur W, et les capacités Cl, suivant sa longueur L. Si on prend l'exemple du noeud technologique 45 nanomètres, ces capacités parasites de bord sont de l'ordre de 0.2 femto farad ($10^{-15}$ farad) par micromètre de largeur W ou de longueur L. Les capacités Cw comprennent les capacités, via les espaceurs, et les capacités via l'oxyde, entre la grille et les diffusions de source et drain. C'est ce qui est illustré sur la figure 2, pour les capacités Cw suivant la largeur W: la capacité parasite c9 correspond à l'empilement électrode de grille $g_e$ /espaceur e1/diffusion S ; et la capacité parasite c10 correspond à l'empilement électrode de grille $g_e$ /oxyde de grille $g_{ex}$/diffusion S. Les capacités Cl sont liées aux capacités spécifiques observées en bord de zone active.

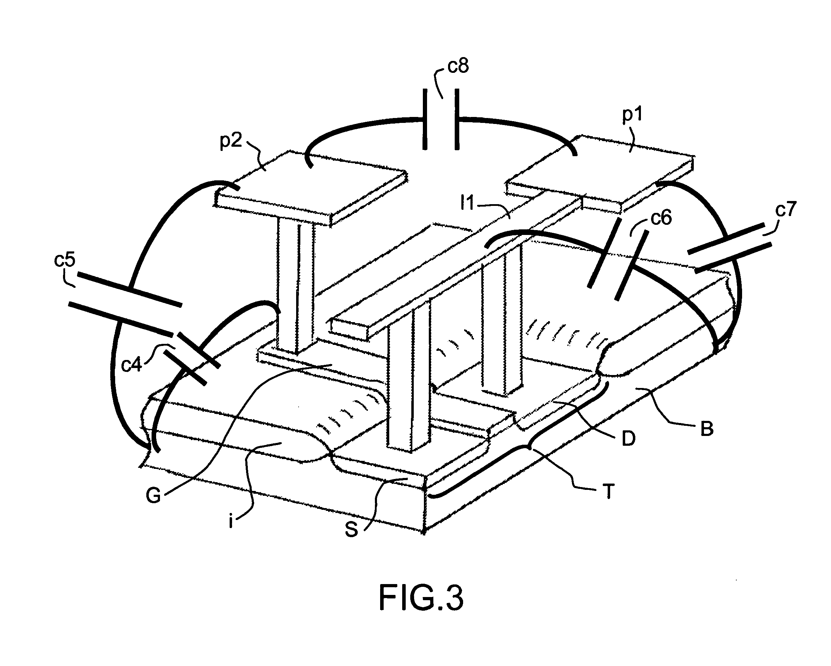

La figure 3 illustre les capacités parasites induites par les plots de test prévus sur le dispositif semi-conducteur, pour recevoir les pointes de mesure (électrodes) de l'appareil de mesure, et par les lignes d'interconnexions, typiquement des lignes d'aluminium, qui permettent de relier la grille et les diffusions de source et drain à ces plots de test. Dans l'exemple, le dispositif semi-conducteur est un transistor MOS T formé dans un substrat semi-conducteur B, et comprenant un canal cc entre deux diffusions de source S et drain D formées dans le substrat, et une grille G (électrode de grille et oxyde de grille, non distingués sur la figure). Le dispositif présente deux plots de test p1 et p2 sur chacun desquels une pointe de mesure d'un appareil de mesure non représenté sera posée. Ces plots sont réalisés dans un même plan de surface, typiquement dans un niveau de métal du dispositif, au-dessus du niveau de grille du transistor. Ce sont par exemple des pavés métalliques de quelques dizaines de micromètres carré. Une ligne de connexion l1 qui comprend le plot de test p1, connecte les deux diffusions par des prises de contact correspondantes. La grille G se prolonge au-delà du canal du transistor, dans une zone où elle est isolée du substrat par un diélectrique épais i, permettant la connexion de la grille à l'autre plot de test p2, par une prise de contact correspondante. Les capacités liées aux éléments d'interconnexion (plots de test, ligne d'interconnexion, ou prises de contact) comprennent notamment les capacités suivantes : la capacité c4 entre la prise de contact de grille du plot p2 et le substrat ; la capacité c5 entre le plot p2 et le substrat ; la capacité c6 entre la ligne de connexion II et le substrat ; la capacité c7 entre le plot p1 et le substrat ; la capacité c8 entre les deux plots p1 et p2, fonction de la distance entre les deux plots. Si on prend l'exemple du noeud technologique 45 nanomètres, la grandeur de chacune des capacités d'interconnexion c5 et c7 induites par des plots de test (p1 ou p2) de 100 microns sur 100 microns est de l'ordre du picofarad. En pratique, selon la topologie des éléments d'interconnexions par rapport au substrat, on observe une dispersion de l'ordre de 10 pour cent des capacités d'interconnexion, notamment quand ces capacités sont formées avec le diélectrique d'isolation i, pour lequel les contraintes de fabrication sont moindres par rapport aux contraintes existant sur l'oxyde de grille.

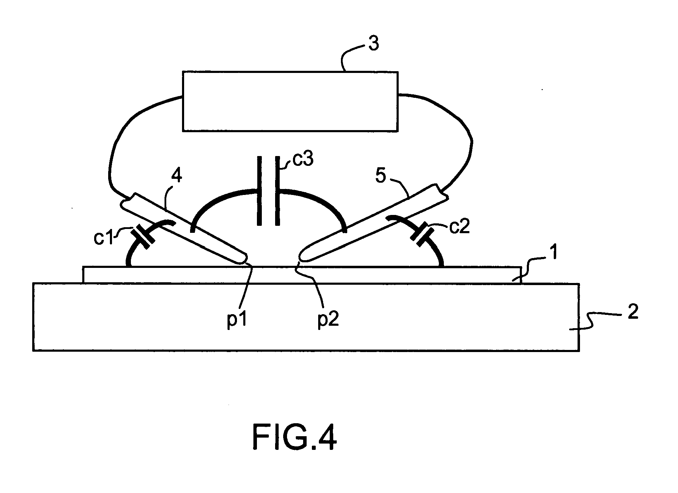

La figure 4 illustre enfin les capacités parasites c1, c2, c3 associées à un appareil de mesure 3, qui comprend typiquement un capacimètre et un dispositif de manipulation (ou "*prober*" suivant la terminologie anglo-saxonne). Un dispositif semi-conducteur quelconque à tester, référencé 1, est disposé de manière classique sur un porte-substrat 2, L'appareil de mesure 3 contrôle deux pointes de mesure 4 et 5, qui sont appliquées en deux points de test sur le dispositif semi-conducteur. Les capacités parasites sont les capacités c1 et c2 entre chaque pointe et le substrat, et la capacité parasite c3 entre les deux pointes. L'ensemble de ces capacités parasites peut atteindre une valeur de l'ordre du picofarad ($10^{-12}$ farad). Cette valeur varie selon la configuration des pointes et leur position vis à vis de porte-substrat.

Pour les filières technologiques avancées qui nous intéressent, ces différentes capacités parasites sont de l'ordre de grandeur des capacités à mesurer.

Enfin, les mesures sont encore affectées par la tolérance sur les dimensions de la structure MOS. En effet, pour faciliter les comparaisons technologiques, la valeur de la capacité est habituellement calculée par unité de surface, c'est à dire que dans les courbes C(V) exploitées, la capacité mesurée est divisée par la surface de la structure MOS sur laquelle on a effectué le relevé. La précision des courbes C(V) obtenues dépend alors de la précision sur les dimensions de la structure MOS, que l'on peut évaluer à 12 pour cent de la longueur nominale de la technologie considérée, d'après les critères de l'ITRS (dispersion à $3\sigma$).

Ainsi, aux imprécisions liées à ces capacités parasites, s'ajoutent les imprécisions sur les dimensions des transistors. On a vu en effet que l'on calculait en réalité une capacité par unité de surface. On divise donc une capacité mesurée par la surface du transistor c'est-à-dire le produit de sa largeur W par sa longueur L, comme défini en relation avec la figure 1.

Dans l'invention, on cherche ainsi à relever de manière fiable les courbes C(V) d'une structure MOS, c'est-à-dire d'un empilement grille oxyde semi-conducteur, spécialement adapté pour les filières nanométriques ou subnanométriques.

Des solutions aux problèmes de précision sur des mesures de capacité ont déjà été cherchées. En particulier des techniques sont connues qui permettent de s'affranchir des éléments parasites amenées par l'appareil de mesure.

On connaît du brevet US 7 069 525, un procédé de caractérisation de structures MOS au moyen d'oscillateurs en anneaux utilisant des inverseurs qui sont connectés en sortie à des charges différentes réalisées par des capacités MOS de longueurs de grille différentes. A partir des différents courants mesurés dans les inverseurs, on remonte aux valeurs des capacités de charge par étage d'inverseur. Sont ainsi mesurés par différentiation, la valeur de la capacité d'oxyde de grille et la dispersion avec la longueur de grille. Cependant ce procédé n'intègre pas les effets quantiques qui sont à considérer pour déterminer la capacité d'oxyde de grille. En outre les mesures ne tiennent pas compte du courant de commutation propre à chaque inverseur, et qui varie en fonction de la charge de l'inverseur.

Une autre technique de mesure connue pour mesurer la valeur d'une capacité d'interconnexion, basée sur la charge d'inverseur, permet par une mesure dynamique, d'éliminer ce courant de commutation, ainsi que les perturbations amenées par les capacités parasites dues aux sondes utilisées et à l'appareil de mesure. Cette technique est décrite dans la publication de B. W. McGaughy, J.C. Chen, D. Sylvester, C. Hu, "A Simple Method for On-Chip Sub-Femto Farad Interconnect Capacitance Measurement," IEEE Electron Device Letters, Vol. 18, No. 1, pp. 21-23, January 1997. Elle est basée sur l'utilisation de deux inverseurs CMOS, l'un chargeant une capacité d'interconnexion à mesurer, et la sortie de l'autre n'étant reliée à aucune charge. Des signaux de commande des inverseurs de forme appropriée permettent de s'affranchir des courants de commutation propre à chaque inverseur.

Le document US2005090916 décrit une structure et une méthode pour obtenir des informations en divers points lors du procédé de fabrication d'une galette semiconductrice. Ces informations sont obtenues sans contact et de manière non invasive afin de préserver l'utilité de la galette lors des étapes de fabrication suivante.

Le brevet US 6 870 375 décrit l'utilisation d'une technique similaire, toujours pour mesurer des capacités d'interconnexion.

Ces capacités d'interconnexion ne sont pas de même nature que la capacité MOS. En particulier la capacité d'interconnexion n'a pas de capacités parasites perturbant la mesure, et elle a une valeur constante quelle que soit la tension appliquée.

Ainsi si ces techniques sont bien adaptées pour la mesure avec précision de faibles capacités d'interconnexion, elles ne permettent cependant pas de s'affranchir des autres capacités parasites telles que les capacités parasites propres à la structure du transistor MOS, ni du problème de précision sur la surface. Or on a vu que ces capacités parasites sont de l'ordre de grandeur de la capacité MOS que l'on cherche à mesurer avec précision.

Un objet de l'invention est une structure de test à base de transistors MOS qui permet de relever les courbes C(V) de manière fiable.

Dans l'invention, une structure de test est définie qui utilise des différences de dimensions de transistors MOS, permettant d'annuler par

différence les différents effets des capacités parasites, et des imprécisions sur les surfaces des transistors.

Dans l'invention, on s'intéresse aussi à un procédé de mesure utilisant une telle structure de test, par lequel les effets parasites liés à la mesure sont aussi annulés.

Telle que caractérisée, l'invention concerne donc une structure capacitive comportant deux dispositifs semi-conducteurs, un premier et un deuxième, chaque dispositif comprenant des transistors MOS dont les grilles sont toutes reliées électriquement entre elles à un premier noeud et les sources et drains sont tous reliés électriquement entre eux à un deuxième noeud, les transistors des deux dispositifs étant de même type, et dont les dimensions sont choisies en sorte que la somme des longueurs, respectivement la somme des largeurs, soient égales dans les deux dispositifs, et que la différence de surface entre les deux dispositifs, donnée par l'équation $S_{equiv} = \Sigma(L_i \cdot W_i) - \Sigma(L'_i \cdot W'_i)$, soit non nulle, où

- $L_i$, $W_i$ désignent respectivement la longueur et la largeur d'un transistor $T_i$ du premier dispositif de la paire ; et $-L'_i$, $W'_i$. désignent respectivement la longueur et la largeur d'un transistor $T'_i$ du deuxième dispositif.

Dans un mode de réalisation de l'invention, les deux dispositifs comportent le même nombre n de transistors.

Un procédé de mise en oeuvre d'une telle structure de test pour la mesure d'une courbe de capacité en fonction de la tension comprend la mesure d'une courbe capacité en fonction de la tension sur chaque dispositif, et le calcul de la courbe résultante différence entre les deux dispositifs rapportée à la différence de surface entre les deux dispositifs.

Le procédé peut utiliser un capacimètre.

Dans une variante, la structure de test comprend en outre un inverseur CMOS par dispositif semi-conducteur, permettant l'utilisation d'un procédé de mesure dynamique.

D'autres avantages et caractéristiques de l'invention sont détaillés dans la description suivante en référence aux dessins illustrés d'un mode de réalisation de l'invention, donné à titre d'exemple non limitatif. Dans ces dessins :

- la figure 1 est un schéma simplifié montrant les capacités de bord et d'angle d'un transistor MOS de dimensions (L, W);
- la figure 2 est une coupe transversale d'un transistor MOS, mettant en évidence les capacités parasites de bord de grille sur zone active;
- la figure 3 illustre les capacités parasites amenées par les lignes d'interconnexion et les plots de test dans la structure à mesurer;
- la figure 4 illustre les capacités parasites amenées par les pointes de test amenées sur les plots de test de la structure;
- les figures 5a et 5b illustrent le dispositif de mesure de capacité d'interconnexion proposé dans la publication de McGaughy et al;
- la figure 6 est un schéma général d'une structure de test selon l'invention;
- les figures 7a et 7b illustrent schématiquement un procédé de mesure et un dispositif de mesure associé utilisant une structure de test selon l'invention;
- les figures 8 et 9 illustrent un premier mode de réalisation d'une structure de test selon l'invention;
- les figures 10a à 10d illustrent un aspect de l'invention permettant de définir une structure MOS équivalente avantageuse;

- les figures 11 et 12 illustrent un deuxième mode de réalisation d'une structure de test selon l'invention ;
- la figure 13 illustre un autre dispositif de mesure de la capacité d'oxyde d'une structure MOS utilisant un procédé de mesure de courant dans des inverseurs en commutation;
- la figure 14 illustre le principe d'extraction de la différence de charge entre deux dispositifs de la structure MOS selon l'invention avec un tel procédé de mesure;
- la figure 15 est un organigramme d'un procédé de mesure correspondant aux figures 13 et 14.

Une structure de test selon l'invention permettant de caractériser de manière précise un empilement MOS comporte deux dispositifs semi-conducteurs comprenant des transistors MOS dont les dimensions sont choisies en sorte que la somme des longueurs, respectivement la somme des largeurs, soient égales dans les deux dispositifs, et que la différence de surface des deux dispositifs, soit non nulle.

On rappelle que l'on entend habituellement par dimensions d'un transistor MOS, la largeur W et la longueur L de la zone de grille surplombant la zone active, comme illustré sur la figure 1. La surface de ce transistor est par suite donnée par le produit de sa largeur W par sa longueur L. La capacité MOS associée est la capacité entre la grille et le substrat (ou le caisson, selon le type de transistor), mesurée entre la grille du transistor MOS, et la source, le transistor MOS ayant sa source court-circuitée à son drain (et le cas échéant à une prise de contact de polarisation du caisson, dans le cas d'un transistor réalisé dans un caisson).

La mesure des capacités sur chacun des dispositifs séparément, puis le calcul de la différence entre ces deux capacités, est équivalente à la mesure d'une capacité de surface équivalente, égale à la différence de surface des deux dispositifs. Les effets parasites induits par les deux dispositifs s'annulent dans cette mesure, par soustraction.

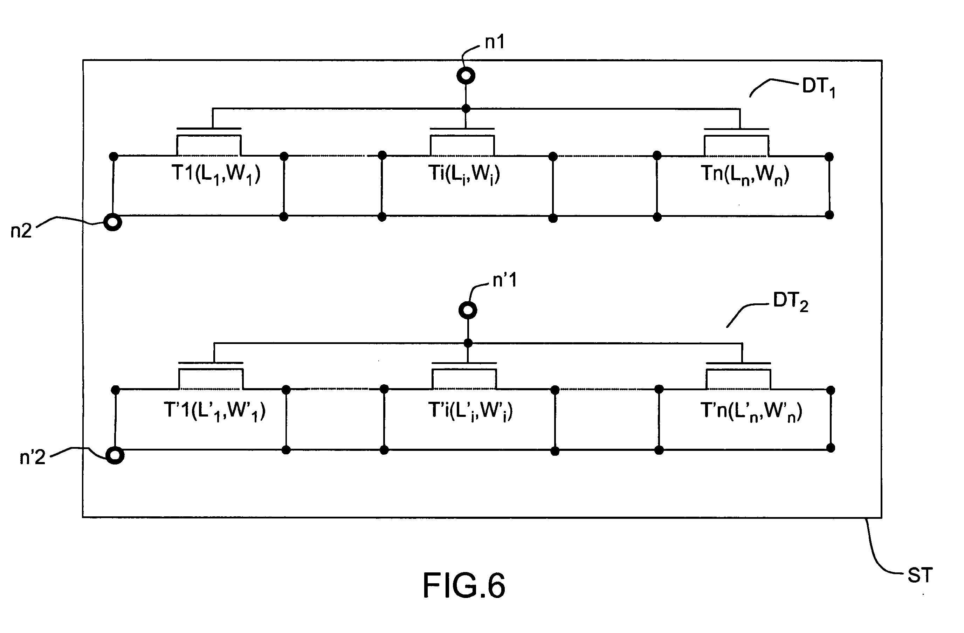

Une structure de test ST selon une mise en oeuvre de l'invention est illustrée sur la figure 6.

Elle comprend au moins un premier dispositif $DT_1$ et un deuxième dispositif $DT_2$ réalisés sur le même substrat. Ils sont réalisés à proximité l'un de l'autre, suffisamment proche l'un de l'autre pour pouvoir négliger la dispersion des dimensions.

Le premier dispositif contient n transistors en parallèle, n entier supérieur ou égal à 2, ayant leurs grilles connectées en commun, et leurs sources et drains connectés en commun, chaque transistor Ti, i=1 à n, étant défini par sa longueur $L_i$, sa largeur $W_i$, et une surface $S_i = L_i.W_i$.

$DT_1$ est ainsi équivalent à une capacité totale équivalente de surface $S1 = \sum (L_i.W_i)_{i=1 \text{ à } n}$.

Le second dispositif contient également n transistors, ayant leurs grilles connectées en commun, et leurs sources et drains connectés en commun, chaque transistor T'i, i=1 à n, étant défini par sa longueur $L'_i$, sa largeur $W'_i$ (i=1...n) et sa surface $S'_i = L'_i.W'_i$.

$DT_2$ est ainsi équivalent à une capacité totale équivalente de surface $S2 = \sum (L'_i.W'_i)_{i=1 \text{ à } n}$.

Les dimensions des transistors des deux dispositifs sont choisies en sorte que :

- la somme des longueurs des transistors Ti du dispositif $DT_1$ égale la somme des longueurs des transistors T'i du dispositif $DT_2$ :

$$\sum (L_i)_{i=1 \text{ à } n} = \sum (L'_i)_{i=1 \text{ à } n} \ ;$$

- la somme des largeurs des transistors $T_i$ du dispositif $DT_1$ égal la somme des largeurs des transistors $T'_i$ du dispositif $DT_2$:

$$\sum (W_i)_{i=1 \text{ à } n} = \sum (W'_i)_{i=1 \text{ à } n} \ ;$$

- la surface différente notée $S_{equiv}$ entre les surfaces $S_1$ et $S_2$ est non nulle: soit

$$S_{equiv} = \sum(L_i.W_i) - \sum(L'_i.W'_i) \neq 0.$$

Dans chaque dispositif, les n transistors ont leurs grilles électriquement reliées en commun, à un premier noeud, n1 dans $DT_1$, n'1 dans $DT_2$.

Dans chaque dispositif, les n transistors ont leurs sources et drains électriquement reliés en commun à un deuxième noeud n2 dans $DT_1$, n'2 dans $DT_2$.

Les transistors des deux dispositifs sont tous de même type, à canal N ou à canal P. Dans le cas où ils seraient réalisés dans des caissons, une prise de caisson est prévue qui sera alors connectée en commun avec les connexions de drain et de source.

La structure de test ST de l'invention permet de mesurer une capacité MOS "différence" entre les deux dispositifs, correspondant à la capacité d'une capacité MOS de surface équivalente $S_{equiv}$. On a

$$S_{equiv} = \Sigma(L_i .W_i) - \Sigma(L'_i .W'_i). \qquad \text{Eq.1}$$

Cette mesure est insensible aux différentes sources de capacités parasites.

En outre, la surface équivalente "différence" est aussi insensible aux dispersions technologiques des dimensions.

Le rapport de la valeur de cette capacité MOS "différence" à la surface équivalente, donne une mesure de la capacité MOS par unité de surface fiable, précise, pour la technologie considérée.

La structure de test ST selon l'invention permet ainsi une mesure de capacité par unité de surface très fiable et précise, indépendante des différents éléments parasites et de la dispersion de la technologie. Cette mesure peut utiliser un appareil de mesure quelconque par lequel une courbe C(V) peut être relevée pour chaque dispositif, selon toute technique bien connue.

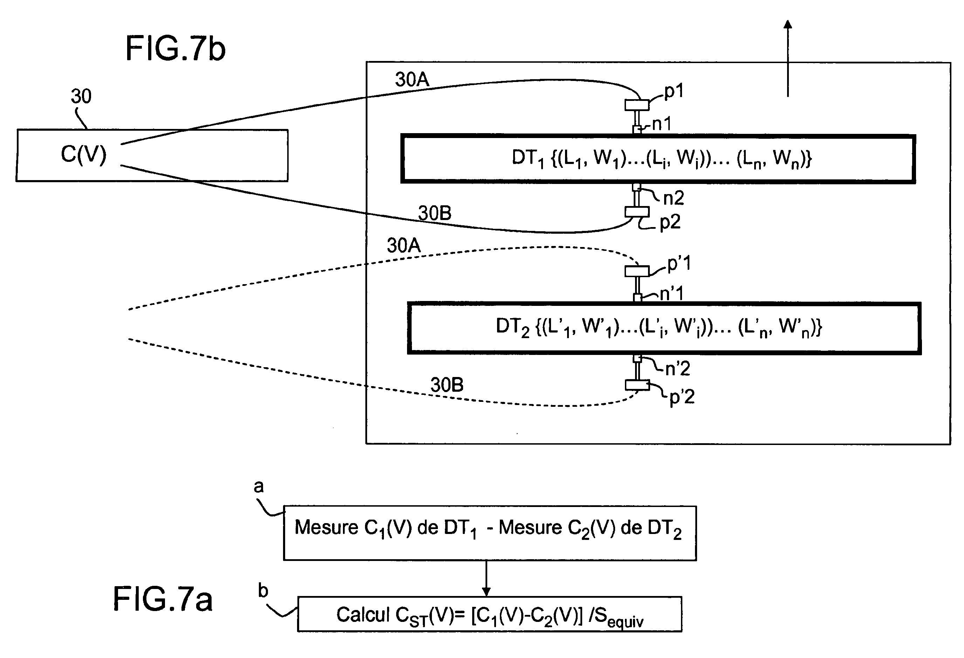

En pratique, comme illustré sur la figure 7b, chacun des noeuds des dispositifs est relié à un plot de test par une structure de connexion respective. Les noeuds n1 et n2 du dispositif $DT_1$ sont ainsi respectivement reliés aux plots p1 et p2. Et les noeuds n'1 et n'2 du dispositif $DT_2$ sont respectivement reliés aux plots p'1 et p'2.

On peut ainsi positionner les deux pointes de mesure 30A et 30B d'un capacimètre 30, typiquement un analyseur d'impédance, sur les plots p1 et p2 du premier dispositif de la structure de test ST, puis sur les plots p'1 et p'2 de l'autre. Le positionnement des sondes sur les plots se fait habituellement au travers d'une carte à pointes disposée sur la structure de test (non représenté).

Les étapes d'un procédé de mesure utilisant une structure de test selon l'invention sont les suivantes (figure 7a) :

a)- mesure de la capacité en fonction de la tension pour chacun de ces deux dispositifs, $C_1(V)$ et $C_2(V)$ respectivement, dans des environnements de mesure similaire, selon les moyens usuels de mesure;

b)- calcul de la différence entre les caractéristiques des deux dispositifs, rapportée à la surface équivalente, $S_{equiv}$ soit $[C_1(V) - C_2(V)]/ S_{equiv}$.

On obtient une caractéristique C(V) par unité de surface insensible aux effets parasites induits par la technologie.

Plus précisément et comme montré sur la figure 7b, dans l'étape a), les deux pointes sont appliquées de la même manière sur les deux dispositifs, c'est-à-dire dans la même configuration : les deux pointes 30A et 30B sont appliquées sur les deux plots $p_1$ et $p_2$ du premier dispositif $DT_1$ pour relever une première courbe caractéristique $C_1$(V) ; et les deux pointes 30A et 30B sont appliquées sur les deux plots $p'_1$ et $p'_2$ du deuxième dispositif $DT_2$ pour relever une deuxième courbe caractéristique $C_2$(V) correspondante.

La courbe par unité de surface obtenue, $[C_1(V) - C_2(V)]/ S_{equiv}$, est ensuite exploitée de manière connue, afin d'obtenir les différents paramètres identifiant la nature de l'empilement électrode de grille/ oxyde de grille /semi-conducteur, notamment son épaisseur, ou sa tension de bandes plates.

Elle est notamment insensible aux capacités parasites de la structure MOS, c'est-à-dire les capacités de bord et d'angles décrites en relation avec les figures 1 et 2. En effet, les conditions sur le nombre de transistors et leurs dimensions, des deux dispositifs $DET_1$ et $DET_2$ de la structure de test entraînent que ces deux dispositifs ont un même périmètre équivalent : la somme totale des longueurs et largeurs, et un même nombre d'angles.

Elle est aussi insensible à la dispersion des dimensions (L, W) des transistors. En effet, les deux dispositifs sont réalisés à proximité, par exemple à moins de 1000 μm entre les deux dispositifs, en sorte que l'on peut admettre qu'il y a conservation de la dispersion technologique sur les dimensions dans les deux dispositifs. Compte tenu de l'égalité des sommes des longueurs et des sommes des largeurs entre les dispositifs $DT_1$ et $DT_2$, si on note respectivement δL et δW, les dispersions technologiques sur les longueurs L et les largeurs W des transistors, c'est à dire l'écart entre les dimensions dessinées (sur les réticules) et les dimensions réelles obtenues, on a l'égalité suivante :

$$\Sigma\{(L_i +\delta L).(W_i+\delta W)\} - \Sigma\{(L'_i +\delta L).(W'_i+\delta W)\} = \Sigma(L_i .W_i) - \Sigma(L'_i .W'_i) \qquad \text{Eq.2.}$$

En d'autres termes, la surface équivalente $S_{equiv}$ est réellement égale $\Sigma(L_i .W_1) - \Sigma(L'_i .W'_i)$, où $L_i$, $W_i$, $L'_i$, et

$W'_i$ sont les dimensions dessinées sur les réticules.

Avantageusement, on peut garantir l'identité des capacités parasites associées aux pointes et aux interconnexions métalliques pour chacun des deux dispositifs, en réalisant des structures de connexion identiques entre p1 et n1 d'une part et p'1 et n'1 d'autre part, et entre p2 et n2 d'une part et p'2 et n'2 d'autre part (Figure 7b). Il faut comprendre par structure de connexion, le plot lui-même et la ligne de connexion entre le noeud et ce plot. Entre les deux dispositifs $DT_1$ et $DT_2$ de la structure de test, ne va alors changer que ce qui est entre n1 et n2 d'une part et n'1 et n'2 d'autre part.

Comme illustré sur la figure 7b, les plots de chaque dispositif de la structure de test sont appelés à se trouver au regard des mêmes pointes de test, par simple déplacement latéral, par exemple par déplacement latéral du substrat de silicium de la structure de test suivant la flèche dessinée sur la figure. Les mesures sur les deux dispositifs sont ainsi réalisées dans des environnements similaires, qui permet de garantir l'insensibilité aux effets parasites amenés par les sondes et l'appareil de mesure. Plus précisément, on peut ainsi garantir que les capacités parasites associées aux pointes et aux interconnections et à l'appareil de mesure, et décrites en relation avec les figures 3 et 4, seront conservées pour les deux mesures $C_1(V)$ et C2(V) : leurs effets s'annuleront par soustraction dans le calcul de la différence $C_1(V)$ - C2(V).

Dans une mise en oeuvre simple de l'invention, les dimensions des transistors d'un dispositif sont choisies en prenant les dimensions des transistors de l'autre dispositif, mais en "associant" de manière différente les longueurs et les largeurs, en sorte que la longueur totale et la largeur totale soient chacune conservées, mais que la différence de surface soit non nulle : $S_{equiv} \neq 0$.

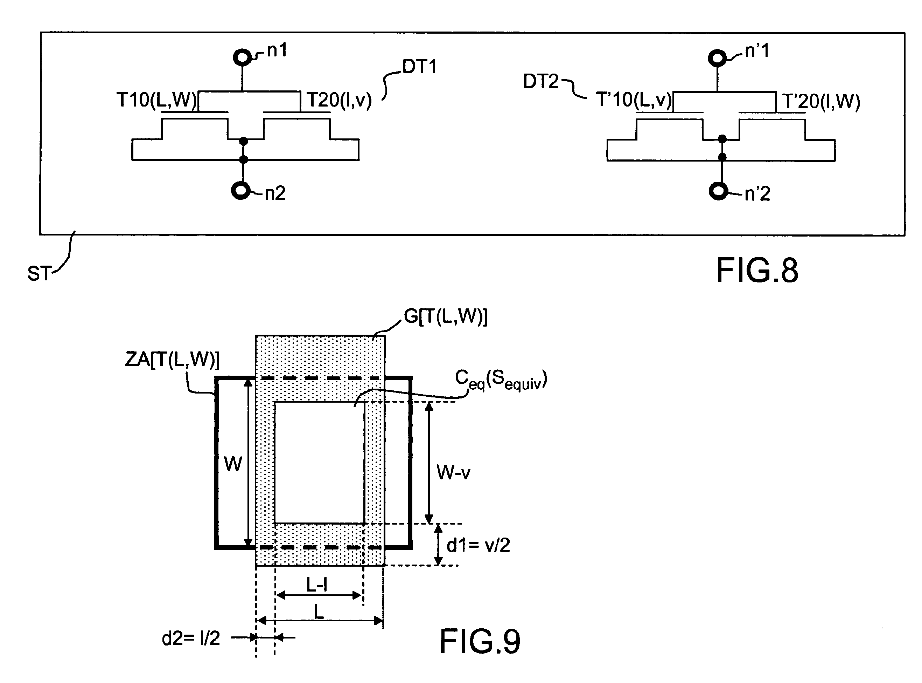

Dans un premier exemple illustrant une telle mise en oeuvre, et comme illustré sur la figure 8, la structure de test comprend au moins un premier et un deuxième dispositif $DET_1$ et $DET_2$, comprenant chacun n= 2 transistors MOS.

Le premier dispositif comprend un premier transistor T10 de longueur dessinée L et de largeur dessinée W et un second transistor T20 de longueur dessinée I et de largeur dessinée v, avec L>I et W>v.

Le second dispositif comprend un premier transistor T'10 de longueur dessinée L et de largeur dessinée v et un second transistor T'20 de longueur dessinée I et de largeur dessinée W.

Comme illustré sur la figure 9, la capacité équivalente Ceq obtenue par différence entre ces deux dispositifs a une longueur (L-I) et une largeur (W-v).

Avec les conditions sur les dimensions L,W,I,v, on peut "inscrire " cette capacité équivalente Ceq dans une partie centrale de la surface d'un transistor ayant comme longueur dessinée L, et comme largeur dessinée W (comme T10). Un choix judicieux de I et v permet en outre avantageusement de supprimer par différence les effets de bord de grille.

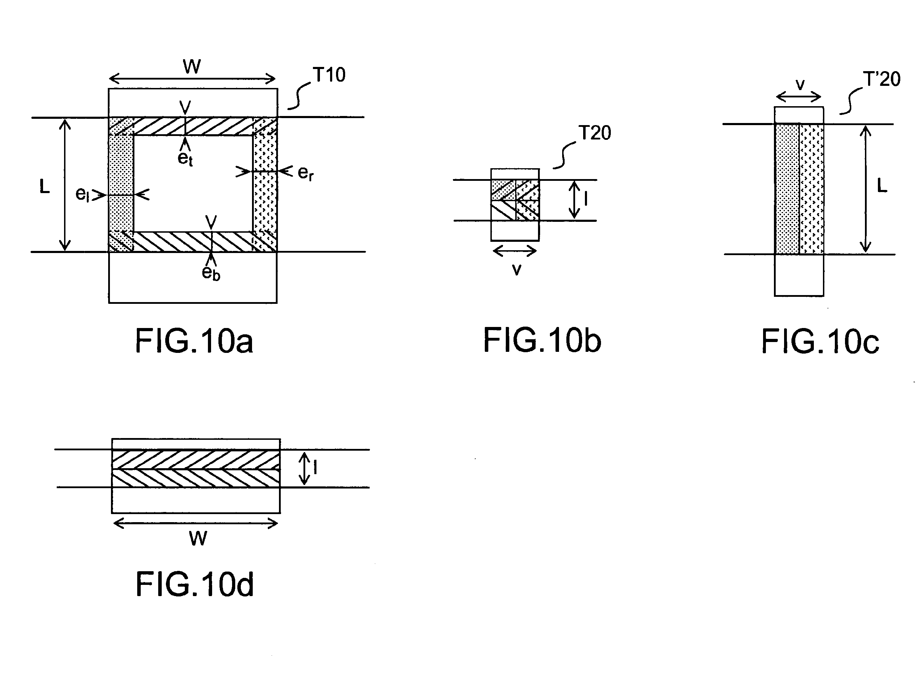

En effet, comme représenté sur la figure 10a, l'oxyde de grille d'un transistor MOS n'est pas toujours homogène sur toute la longueur L et sur toute la largeur W de la grille, en particulier sur les bords de grille, correspondant aux bords de gravure. On peut ainsi distinguer les deux zones zt (hachurée dans un sens) et zb (hachurée dans l'autre sens), correspondant aux bords des zones actives sous la grille selon la largeur W, dans lesquelles l'oxyde de grille est affecté par les effets de bord selon cette dimension et les deux zones zl (pointillée) et zr (marquée de croix), correspondant aux bords de grille selon la longueur L, dans lesquelles l'oxyde de grille est affecté par les effets de bord selon cette dimension. Si I et v sont choisis en sorte que la largeur v des transistors T20 et T'20 (figures 10b et 10c) correspond à la somme des largeurs $e_l$ et $e_r$ des deux zones zl et zr, et que la longueur I des transistors T20 et T'10 (figures 10b et 10d), soit égale à la somme des longueurs $e_t$ et $e_b$ des deux zones zt et zb, on obtient une structure MOS équivalente sans effets de bord.

D'autres combinaisons sont possibles, si on veut n'exclure que certaines zones, par exemple seulement les zones de bord "horizontales" zt, et zb.

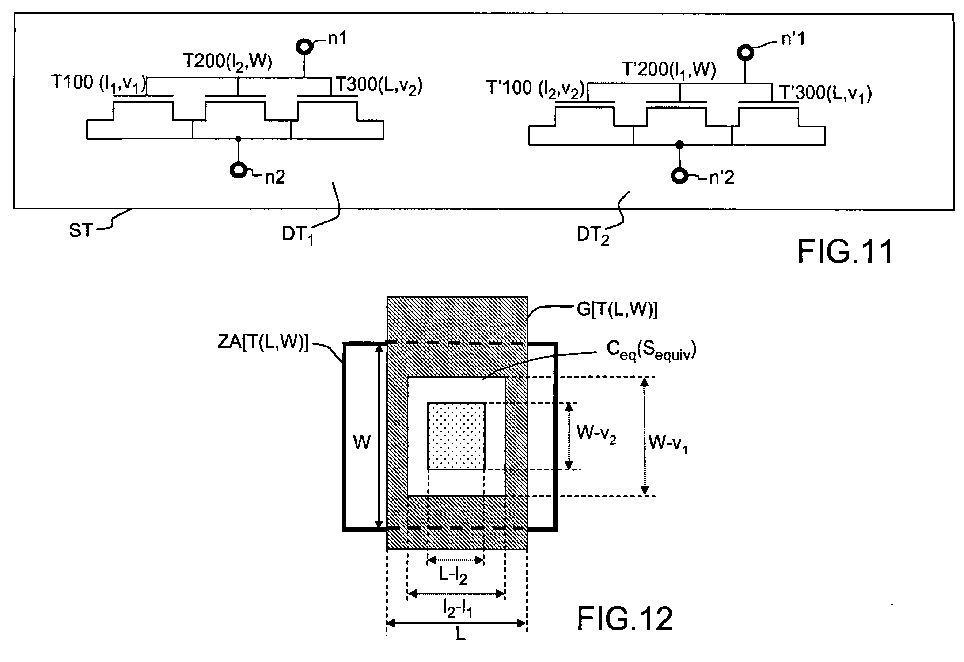

Les figures 11 et 12 illustrent un deuxième exemple d'une mise en oeuvre simple de l'invention, selon laquelle les dimensions des transistors d'un dispositif de la structure de test sont choisies en prenant les dimensions des transistors de l'autre dispositif, mais en "associant" de manière différente les longueurs et les largeurs, en sorte que la longueur totale et la largeur totale soient conservées, mais que la différence de surface soit non nulle.

La structure de test ST comprend ici deux dispositifs $DET_1$ et $DET_2$, dans laquelle chaque dispositif est constitué de n= trois transistors MOS. Le premier dispositif comprend un premier transistor T100 de longueur dessinée $I_1$ et de largeur dessinée $v_1$, un second transistor T200 de longueur dessinée $I_2$ et de largeur dessinée W et un troisième transistor T300 de longueur dessinée L et de largeur dessinée $v_2$ (L> $I_2$ > $I_1$ et W> $v_2$ > $v_1$ ).

Le deuxième dispositif comprend un premier transistor T100' de longueur dessinée $I_2$ et de largeur dessinée $v_2$, un second transistor T200' de longueur dessinée $I_1$ et de largeur dessinée W et un troisième transistor T300' de longueur dessinée L et de largeur dessinée $v_1$.

La capacité équivalente Ceq obtenue par différence entre ces deux dispositifs est un anneau que l'on peut inscrire dans la surface d'un transistor de longueur dessinée L, et de largeur dessinée W, dans la partie centrale de cette surface.

Cet anneau est caractérisé par une longueur extérieure (L- $I_1$), une longueur intérieure (L- $I_2$), une largeur extérieure (W- $v_1$) et une largeur intérieure (W- $v_2$). Il est illustré sur la figure 12 : c'est la partie laissée blanche entre la partie en pointillé au centre et la partie hachurée en périphérie.

En comparant le transistor défini par des dimensions (L,W), comme illustré sur la figure 10a, et l'anneau illustré sur la figure 12, on comprend qu'en faisant varier $l_1$, $v_1$, $l_2$, $v_2$, la surface équivalente de la structure de test ST a une forme d'anneau qui s'inscrit dans la surface de dimension L.W, à une distance du périmètre qui est fonction des dimensions $l_1$, $v_1$, $l_2$, $v_2$. En faisant varier les dimensions I1, v1, v2, on peut faire varier la distance dudit anneau au périmètre de ladite surface. Ceci permet avantageusement de vérifier les homogénéités de l'empilement de grille selon la distance de l'empilement délimité par l'anneau, au périmètre de la surface L.W (i.e. au bord de grille G du transistor T100).

La structure de test selon l'invention qui vient d'être décrite en relation avec les figures 6 à 12, peut être utilisée de manière bien connue, dans un procédé de mesure de caractéristique C(V) comme illustré sur la figure 7a, avec un capacimètre ou analyseur d'impédance, pour mesurer les deux courbes $C_1(V)$, $C_2(V)$ (étape a. du procédé), et calculer leur différence, rapportée à la surface équivalente donnée par Eq.1 (étape b). du procédé).

La structure de test proposée permet ainsi de caractériser simplement et de manière précise et fiable l'empilement MOS au moyen d'un capacimètre. Elle est simple et peu coûteuse à réaliser.

Selon un autre aspect de l'invention, en plaçant les dispositifs chacun comme charge d'un inverseur CMOS commandé de manière appropriée, cette courbe peut être relevée par un procédé de mesure dynamique, basé sur la mesure du courant dans chaque inverseur.

Une telle technique de mesure dynamique est décrite dans la publication précitée de McGaughy et al, pour la mesure d'une capacité d'interconnexion.

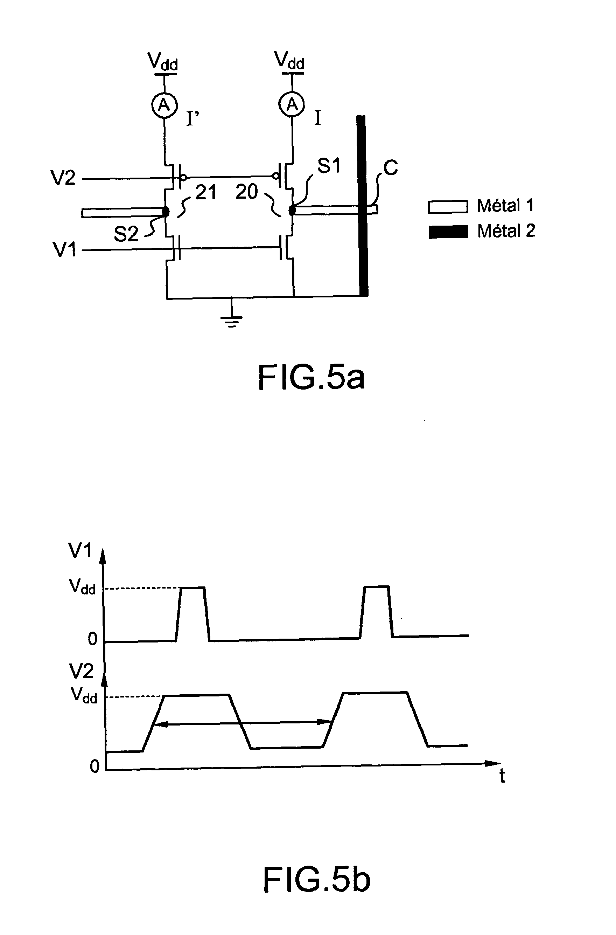

La technique décrite dans cette publication est illustrée sur les figures 5a et 5b de la présente demande.

La capacité d'interconnexion C à mesurer, produite par le croisement de deux lignes de métal 10 et 11, chacune sur un niveau topologique différent, Metal1 et Metal2, est placée comme capacité de charge d'un premier inverseur CMOS 20, c'est à dire entre le noeud de sortie S1 de cet inverseur et la masse. Un deuxième inverseur CMOS 21 est prévu, qui est identique au premier, sauf en ce que sa sortie S2 n'est pas reliée à une capacité de charge (figure 5a). Les deux inverseurs 20, 21 sont alimentés entre une tension d'alimentation Vdd et la masse, et sont respectivement commandés par un signal périodique impulsionnel de même fréquence, respectivement V1 et V2, et dont le niveau haut de l'impulsion correspond au niveau de la tension continue Vdd (figure 5b).

Les signaux V1 et V2 sont des signaux qui ne se recouvrent pas, en sorte qu'à tout moment dans un inverseur un transistor au maximum conduit du courant, ce qui permet d'éliminer les courants de commutation propres à chaque inverseur. Une mesure des courants de charge I est I' dans chaque inverseur 20, 21 est réalisée.

Pour s'affranchir des capacités parasites des transistors MOS des inverseurs, les inverseurs sont choisis identiques, et réalisés à proximité l'un de l'autre, en sorte qu'ils aient sensiblement les mêmes capacités parasites : les effets des capacités parasites des deux inverseurs s'annulent alors complètement dans la différence I-I', et la valeur de la capacité d'interconnexion C est ainsi déduite par l'équation suivante :

$$(I-I')/f = CV_{dd}, \qquad (Eq.3).$$

où $V_{dd}$ est l'amplitude de tension des signaux V1 et V2 ainsi que la tension de polarisation des deux inverseurs, f la fréquence du signal de tension appliqué aux inverseurs, et I est I' les courants d'alimentation dans les inverseurs. C est invariant avec la tension. Donc une mesure des courants I est I' à Vdd et f donnés donne la valeur de C.

Pour vérifier la mesure, on peut faire varier au choix Vdd, ou la fréquence f : la valeur C de la capacité d'interconnexion est égale à la pente de la courbe correspondante I(Vdd) ou I(f) rapportée à la fréquence f, respectivement la tension Vdd de mesure.

Dans l'invention, on a cherché à appliquer cette technique de mesure dynamique pour la mesure de la caractéristique C(V) d'une capacité MOS en utilisant une structure de test selon l'invention. L'idée est d'utiliser les deux dispositifs $DT_1$ et $DT_2$ de la structure de test selon l'invention, chacun comme capacité de charge d'un inverseur, selon le principe exposé dans la publication précitée.

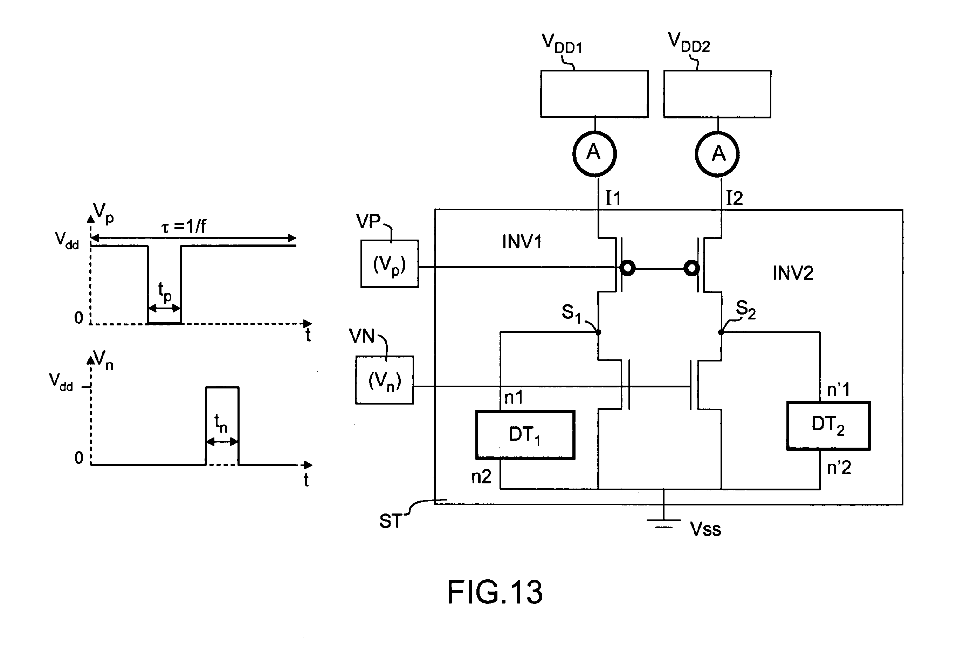

Une mise en oeuvre du principe de la mesure dynamique associé à une structure de test ST selon l'invention, par exemple la structure de la figure 8 ou de la figure 11, est illustrée à la figure 13.

La structure de test ST comprend en plus des deux dispositifs $DT_1$ et $DT_2$, deux inverseurs CMOS INV1 et INV2 connectés entre deux plots d'alimentation : INV1 est connecté entre les plots $V_{DD1}$ et Vss; et INV2 est connecté entre les plots $V_{DD2}$ et Vss.

Le premier inverseur INV1 charge le premier dispositif $DT_1$ de la structure de test : sa sortie $S_1$ est connectée au noeud n1. Le noeud n2 est connecté au pied de l'inverseur, typiquement à la masse Vss. Le deuxième inverseur INV2 charge le deuxième dispositif $DT_2$ : sa sortie $S_2$ est connectée au noeud n'1. Le noeud n'2 est connecté au pied de l'inverseur, typiquement à la masse Vss.

Les grilles des transistors de type P des deux inverseurs sont commandées par un même signal $V_p$ appliqué sur le plot VP et les grilles des transistors de type N des deux inverseurs sont commandées par un même signal $V_n$

appliqué sur le plot VN. Le niveau haut des signaux $V_p$ et $V_n$ et le niveau de tension appliqué sur les plots $V_{DD1}$ et $V_{DD2}$ pour polariser les inverseurs sont identiques et égaux à Vdd.

On applique sur les transistors MOS P de l'inverseur un signal de commande $V_p$ de fréquence f qui commande la fermeture des transistors P (c'est à dire à l'état passant) pendant un temps de fermeture ou temps de conduction $t_p$.

On applique sur les transistors MOS N de l'inverseur un signal de commande $V_n$ de fréquence f qui commande la fermeture des transistors N pendant un temps de fermeture $t_n$.

Pour Vdd, f et $t_p$ donnés, on mesure le courant I1, I2 dans chaque inverseur INV1, INV2.

Le courant mesuré I1 dans l'inverseur INV1 à f et Vdd et tp donnés s'écrit alors $I1/f = Q_{inv1} + Q_{DT1} + I_{f1}.t_p$ Eq.4 où $t_p$ est le temps de conduction du transistor P; $Q_{inv1}$, la charge de commutation inhérente à l'inverseur de mesure INV1 et à ses capacités parasites, $I_{f1}$ est le courant de fuite de la capacité à mesurer entre les noeuds n1 et n2 du dispositif $DT_1$ pour un niveau de tension Vdd donné et $Q_{DT1}$, la charge du dispositif $DT_1$ pour une tension Vdd.

On obtient de la même façon le courant mesuré I2 dans l'inverseur INV2 à f et Vdd et $t_p$ donnés, et on a $I2/f = Q_{inv2} + Q_{DT2} + I_{f2}.t_p$ (Eq.4 appliqué à l'inverseur INV2 chargeant $DT_2$).

L'équation Eq.3 de la publication de MacGaughy n'est en effet pas applicable, car dans l'invention la capacité que l'on cherche à mesurer n'est plus constante avec la tension.

Dans la publication de MacGaughy, la capacité C à mesurer (capacité d'interconnexion) n'induisait pas de fuite : c'était une capacité d'interconnexion, d'où la fonction linéaire de la tension exprimée par Eq.3.

Ce n'est plus le cas pour les capacités MOS que l'on cherche à mesurer entre les noeuds n1 et n2 du dispositif $DT_1$, et entre les noeuds n'1 et n'2 du dispositif $DT_2$. Et le courant dans l'inverseur permet seulement une mesure de charge d'une capacité et non de la capacité.

En outre, on a un courant de fuite $If_1$, $I_{f2}$ dans chacun des dispositifs $DT_1$ et $DT_2$, pendant le temps de conduction du transistor $t_p$. Ce courant de fuite varie avec la tension. C'est une inconnue qui parasite la mesure, et dont il faut pouvoir s'affranchir.

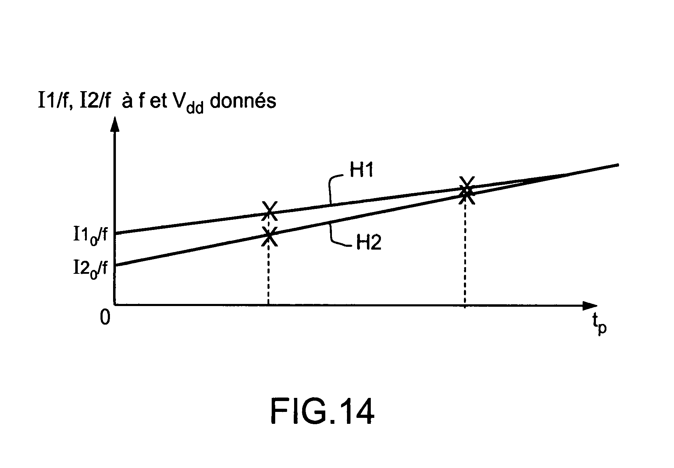

Dans l'invention, et comme illustré sur la figure 14, on s'affranchit de ce terme en mesurant dans chaque inverseur la valeur du quotient courant mesuré sur fréquence de l'équation Eq.4, pour différentes valeurs de $t_p$, à Vdd et f constants, afin de pouvoir tracer une courbe de variation de ce quotient, en fonction du temps de conduction et l'extrapoler à l'origine : on obtient une valeur du quotient courant mesuré sur fréquence correspondant à un temps de conduction $t_p$ nul.

En choisissant deux valeurs de $t_p$ différentes, chacune telles qu'ils autorisent une pleine charge (à Vdd) de la capacité à mesurer, le courant de fuite est alors une fonction linéaire de $t_p$. Il est alors facile d'extrapoler la droite obtenue à l'origine : on obtient par extrapolation une mesure du quotient courant mesuré sur fréquence à $t_p$ nul, ce qui supprime la charge due au courant de fuite dans l'équation Eq.4.

Pour l'inverseur INV1 chargé par le dispositif $DT_1$ de la structure de test, on détermine ainsi la valeur $I1_0/f$ à $t_p$ nul :

$$I1_0/f = Q_{inv1} + Q_{DT1}. \quad [Eq.5A]$$

On détermine de manière similaire la valeur $I2_0/f$ à $t_p$ nul :

$$I2_0/f = Q_{inv2} + Q_{DT2}. \quad [Eq.5B]$$

Les inverseurs INV1 et INV2 sont identiques (i.e. notamment avec les mêmes géométries pour leurs transistors N et pour leurs transistors P) et réalisés très proches l'un de l'autre, typiquement à moins de 1000 micromètres. Ainsi, comme dans la publication précitée, on peut considérer que leurs charges respectives $Q_{inv1}$ et $Q_{inv2}$ sont égales.

Ainsi, dans la différence entre les deux courbes données par Eq.5A et Eq.5B, les charges liées aux inverseurs s'annulent, et on obtient la valeur de la charge différence, à $t_p$ nul entre les deux dispositifs, pour f et Vdd donnés, ce qui s'écrit $(I1_0-I2_0)/f = Q_{DT1} - Q_{DT2}$, pour f et Vdd donnés.

A f constant, en faisant varier la valeur de Vdd, on peut ainsi construire point à point la courbe de la charge différence à $t_p$ nul, en fonction de Vdd :

$$Q_{DT1} - Q_{DT2} = F(Vdd).$$

Le calcul de la dérivée de cette courbe, est la courbe de capacité différence en fonction de la tension entre les

deux dispositifs $DT_1$ et $DT_2$ qui est recherchée :

$$\delta F/\delta V = \delta(Q_{DT1} - Q_{DT2})/\delta V = C_1(V) - C_2(V).$$

En pratique, on fait varier la tension Vdd dans une plage autour de la valeur nominale définie pour la technologie, les limites de la plage étant d'une part la tension maximale acceptable aux bornes des transistors et d'autre part la tension minimale à appliquer pour obtenir la commutation des transistors des inverseurs.

Une structure de test correspondante intégrera donc sur un même substrat (figure 13), deux inverseurs CMOS identiques chargeant chacun l'un des deux dispositifs $DT_1$ et $DT_2$.

Tous ces éléments sont réalisés à proximité de manière à obtenir l'élimination des éléments parasites, par calcul de différence comme expliqué, tant pour les effets de dispersion des dimensions que des charges propres aux inverseurs.

Cette structure de test comporte 5 plots de contact $V_{DD1}$, $V_{DD2}$, VP, VN et Vss, permettant d'amener la tension de polarisation des inverseurs et les tensions de commande $V_p$ et $V_n$ nécessaires à la mesure.

Dans un procédé de mesure correspondant, on applique comme signaux de commande $V_p$ et $V_n$ des transistors des deux inverseurs, des trains d'ondes de même fréquence f, tels que les temps de fermeture $t_p$ du transistor de type P et $t_n$ du transistor de type N de chaque inverseur soient disjoints (figure 13).

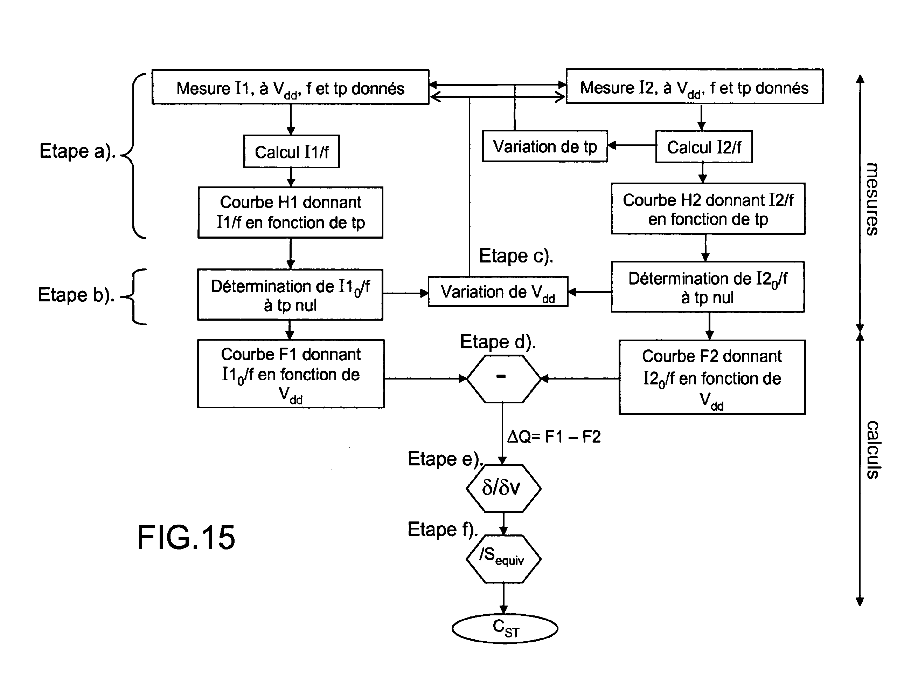

La mesure de la courbe $C_{ST}(V)$ de capacité différence entre les deux dispositifs $DT_1$ et $DT_2$ de la structure de test pourra comprendre les étapes suivantes, comme illustré sur la figure 15 :

a)- mesure des courants d'alimentation I1 et I2 de chaque inverseur pour une fréquence f, un niveau d'alimentation Vdd et un temps de conduction $t_p$ donnés, et calcul du quotient du courant par la fréquence I1/f et I2/f;

b)- répétition de la mesure en a)., pour différentes valeurs du temps de conduction $t_p$ ; tracé des deux courbes H1 et H2 donnant respectivement I1/f et I2/f en fonction du temps de conduction $t_p$ et extrapolation à l'origine, pour obtenir les valeurs extrapolées à $t_p$ nul, $I1_0/f$ et $I2_0/f$, comme illustré sur la figure 14;

c)- répétition des étapes a). et b). pour différentes valeurs de Vdd, à f constant, pour obtenir les courbes F1 et F2 donnant respectivement $I1_0/f$ et $I2_0/f$ en fonction de Vdd;

d)- calcul de la différence entre ces deux courbes F1 et F2, pour obtenir la courbe de la charge différence $\Delta Q = Q_{DT1} - Q_{DT2}$ entre les deux dispositifs $DT_1$ et $DT_2$, en fonction de la tension Vdd;

e)- calcul de la dérivée $\delta \Delta Q/\delta V$ de cette courbe par rapport à la tension, donnant la courbe de capacité différence entre les deux dispositifs, en fonction de la tension Vdd;

f)-calcul de la courbe $C_{ST}(V)$ de capacité différence entre les deux dispositifs par unité de surface, en fonction de la tension, en retenant comme surface, la surface équivalente $S_{equiv}$ définie en équation Eq.1 :

$$C_{ST}(V) = (\delta \Delta Q/\delta V)/S_{equiv}.$$

Le procédé de mesure comprend ainsi une phase de mesure, avec une première boucle de variation de $t_p$, comprenant les étapes a)- et b)-contenue dans une deuxième boucle de variation de Vdd comprenant l'étape c)-, et une boucle de calcul comprenant les étapes d)-, e)- et f)-.

On notera, comme il ressort de la figure 15, que les boucles de variation de $t_p$ et Vdd appliquées aux deux dispositifs sont les mêmes.

En pratique, l'étape b). d'extrapolation à f et Vdd donnés peut être obtenue par deux mesures, correspondant à deux valeurs du temps de fermeture $t_p$ des transistors P différentes et suffisantes pour autoriser une pleine charge de la capacité à mesurer : c'est-à-dire que $t_p$ est tel que l'on retrouve Vdd entre les noeuds n1 et n2 du dispositif $DT_1$, et entre les bornes n'1 et n'2 du dispositif $DT_2$.

On peut ensuite tracer et exploiter la caractéristique capacité tension selon les moyens usuels de l'extraction des capacités MOS et obtenir des paramètres identifiant la nature de l'empilement grille oxyde semi-conducteur, et plus particulièrement son EOT et sa tension de bandes plates VFB.

Les exemples particuliers de réalisation des dispositifs $DT_1$ et $DT_2$ expliqués en référence aux figures 6 à 12, s'appliquent aussi bien avec l'un ou l'autre des deux procédés de mesure expliqués, avec capacimètre ou avec inverseurs.

**Revendications**

1. Structure de test d'une capacité MOS (ST) comportant deux dispositifs semi-conducteurs, un premier ($DT_1$) et un

deuxième (DT$_2$), chaque dispositif comprenant des transistors MOS dont les grilles sont toutes reliées électriquement entre elles à un premier noeud (n1), et les sources et drains sont tous reliés électriquement entre eux à un deuxième noeud (n2), les transistors des deux dispositifs étant de même type c**aractérisée en ce que** les dimensions des transistors sont choisies en sorte que la somme des longueurs, respectivement la somme des largeurs, soient égales dans les deux dispositifs, et que la différence de surface S$_{equiv}$ entre les deux dispositifs, donnée par l'équation

$$S_{equiv} = \Sigma(L_i \, . W_i) - \Sigma(L'_i \, . W'_i),$$

soit non nulle, où

- L$_i$, W$_i$ désignent respectivement la longueur et la largeur d'un transistor T$_i$ d'un premier dispositif DT$_1$ de la paire ; et
- L'$_i$, W'$_i$ désignent respectivement la longueur et la largeur d'un transistor T'$_i$ d'un deuxième dispositif DT$_2$.

2. Structure de test selon la revendication 1, dans laquelle les deux dispositifs comportent le même nombre n de transistors MOS.

3. Structure de test selon la revendication 2, dans laquelle n=2.

4. Structure de test selon la revendication 3, dans laquelle :

- le premier dispositif (DT$_1$) comprend un premier transistor (T10) avec une première longueur L et une première largeur W, et un deuxième transistor (T20) avec une deuxième longueur l est une deuxième largeur v, où L>l et W>v;
- le deuxième dispositif (DT$_2$) comprend un premier transistor (T'10) dont la longueur égale ladite première longueur L et dont la largeur égale ladite deuxième largeur v, et un deuxième transistor (T'20) dont la longueur égale ladite deuxième longueur l et dont la largeur égale ladite première largeur W.

5. Structure de test selon la revendication 2, dans laquelle n=3.

6. Structure de test selon la revendication 5, dans laquelle

- le premier dispositif (DT$_1$) comprend un transistor (T100) avec une première longueur l1 et une première largeur v1, un deuxième transistor (T200) avec une deuxième longueur l2 et une deuxième largeur W, et un troisième transistor avec une troisième longueur L et une troisième largeur v2, avec L> l2>l1 et W>v2>v1;
- le deuxième dispositif (DT$_2$) comprend un premier transistor (T'100) dont la longueur égale ladite deuxième longueur l2 et dont la largeur égale ladite troisième largeur v2, un deuxième transistor (T'200) dont la longueur égale ladite première longueur l1 et dont la largeur égale ladite deuxième largeur W, et un troisième transistor (T'300) dont la longueur égale ladite troisième longueur L, et dont la largeur égale ladite première largeur v1.

7. Structure de test selon l'une quelconque des revendications 1 à 6, comprenant dans chacun desdits dispositifs, une première structure de connexion pour relier le premier noeud (n1, n1') à un premier plot de test (p1, p1') et une deuxième structure de connexion pour relier le deuxième noeud (n2, n2') à un deuxième plot de test (p2, p2').

8. Structure de test selon la revendication 7, dans laquelle les premières structures de connexion, respectivement les deuxièmes structures de connexion, sont identiques pour les deux dispositifs.

9. Structure de test (ST) selon l'une quelconque des revendications 1 à 6, comprenant en outre deux inverseurs CMOS identiques (INV1, INV2), chaque inverseur chargeant un dispositif respectif parmi le premier (DT$_1$) et le deuxième (DT$_2$), les transistors de type P des deux inverseurs recevant un signal de commande commun (V$_p$) et les transistors de type N des deux inverseurs recevant un signal de commande commun (V$_n$), lesdits signaux de commande des transistors P et N étant du type non recouvrants.

10. Structure de test selon la revendication 9, **caractérisée en ce que** les deux inverseurs sont réalisés à proximité l'un de l'autre, typiquement à une distance inférieure à 1000 micromètres.

**11.** Procédé de mise en oeuvre d'une structure de test (ST), pour relever une courbe ($C_{ST}(V)$) de capacité différence en fonction de la tension entre un premier ($DT_1$) et un deuxième ($DT_2$) dispositifs de ladite structure de test, chaque dispositif comprenant des transistors MOS dont les grilles sont toutes reliées électriquement entre elles à un premier noeud (n1), et les sources et drains sont tous reliés électriquement entre eux à un deuxième noeud (n2), les transistors des deux dispositifs étant de même type, et les dimensions des transistors étant choisies en sorte que la somme des longueurs, respectivement la somme des largeurs, soient égales dans les deux dispositifs, et que la différence de surface $S_{equiv}$ entre les deux dispositifs, donnée par l'équation

$$S_{equiv} = \Sigma(L_i . W_i) - \Sigma(L'_i . W'_i),$$

soit non nulle, où

- $L_i$, $W_i$ désignent respectivement la longueur et la largeur d'un transistor $T_i$ d'un premier dispositif $DT_1$ de la paire ; et
- $L'_i$, $W'_i$ désignent respectivement la longueur et la largeur d'un transistor $T'_i$ d'un deuxième dispositif $DT_2$, ledit procédé comprenant la détermination de la capacité en fonction de la tension appliquée sur chacun desdits premier et deuxième dispositifs ($DT_1$, $DT_2$), et le calcul de la courbe de capacité différence entre les deux dispositifs en fonction de la tension, ramenée à une courbe de capacité différence par unité de surface, par division par ladite surface équivalente $S_{equiv}$ de la structure de test.

**12.** Procédé selon la revendication 11, chacun desdits premier et deuxième dispositifs comprenant une première structure de connexion pour relier le premier noeud (n1, n1') à un premier plot de test (p1, p1') et une deuxième structure de connexion pour relier le deuxième noeud (n2, n2') à un deuxième plot de test (p2, p2'), dans lequel la tension est appliquée aux bornes desdits premier et deuxième plots de chacun desdits premiers et deuxième dispositif au moyen d'un capacimètre.

**13.** Procédé selon la revendication 12, où lesdites premières structures de connexion, respectivement lesdites deuxièmes structures de connexion, sont identiques pour les deux dispositifs.

**14.** Procédé selon la revendication 11, la structure de test (ST) comprenant en outre deux inverseurs CMOS identiques (INV1, INV2), chaque inverseur chargeant un dispositif respectif parmi le premier ($DT_1$) et le deuxième ($DT_2$), les transistors de type P des deux inverseurs recevant un signal de commande commun ($V_p$) et les transistors de type N des deux inverseurs recevant un signal de commande commun ($V_n$), lesdits signaux de commande des transistors P et N étant du type non recouvrants, ledit procédé appliquant des signaux de commande de commutation à une fréquence f auxdits transistors de type N et P des inverseurs, assurant un temps de conduction des transistors P disjoint du temps de conduction des transistors N, et ledit procédé comprenant la succession d'étapes de mesure suivantes :

pour chaque inverseur et son dispositif de charge associé:

a)- mesure des courants d'alimentation (I1,I2) de chaque inverseur, pour une fréquence de commutation (f) et une tension d'alimentation Vdd des inverseurs données, en fonction du temps de conduction ($t_p$) du transistor de type P, pour obtenir une première courbe (QI1, QI2) donnant le quotient courant mesuré sur fréquence (I1/f, I2/f), en fonction dudit temps de conduction,
b)- extrapolation de ladite première courbe à l'origine, pour obtenir une valeur de quotient courant mesuré sur fréquence extrapolé à l'origine ($I1_0/f$, $I2_0/f$) correspondant à un temps de conduction du transistor P nul,
c)- répétition des étapes a). et b). pour différentes valeurs de la tension d'alimentation (Vdd), permettant d'obtenir une deuxième courbe (F1, F2) donnant le quotient courant extrapolé à l'origine sur fréquence ($I1_0/f$, $I2_0/f$), en fonction de la tension d'alimentation (Vdd),

puis
calcul de la courbe ($C_{ST}(V)$) de capacité différence par unité de surface entre les deux dispositifs en fonction de la tenson,
comprenant les étapes suivantes :

d)-calcul de la courbe différence ($\Delta Q$) entre lesdites deuxièmes courbes (F1,F2),

e)-calcul de la dérivée de cette courbe différence par rapport à la tension ($\delta\Delta Q/\delta V$), et

f)-division par ladite surface équivalente $S_{equiv}$ de la structure de test.

**15.** Procédé selon la revendication 14, dans lequel les deux inverseurs de la structure de test sont réalisés à proximité l'un de l'autre, typiquement à une distance inférieure à 1000 micromètres.

**Claims**

**1.** A structure for testing an MOS capacitance (ST) comprising two semiconductor devices, a first ($DT_1$) and a second ($DT_2$), each device comprising MOS transistors, the gates of which are all electrically connected together to a first node (n1), and the sources and drains are all electrically connected together to a second node (n2), the transistors of the two devices being of the same type, **characterised in that** the dimensions of the transistors are selected so that the sum of the lengths and the sum of the widths, respectively, are equal in the two devices, and that the difference in surface area $S_{equiv}$ between the two devices, provided by the equation

$$S_{equiv} = \Sigma(L_i . W_i) - \Sigma(L'_i . W'_i),$$

is non-zero, where

- $L_i$, $W_i$ respectively designate the length and the width of a transistor $T_i$ of a first device $DT_1$ of the pair; and
- $L'_i$, $W'_i$ respectively designate the length and the width of a transistor $T'_i$ of a second device $DT_2$.

**2.** The test structure according to claim 1, wherein the two devices comprise the same number n of MOS transistors.

**3.** The test structure according to claim 2, wherein n=2.

**4.** The test structure according to claim 3, wherein:

- the first device ($DT_1$) comprises a first transistor (T10) with a first length L and a first width W and a second transistor (T20) with a second length 1 and a second width v, where L>1 and W>v;
- the second device ($DT_2$) comprises a first transistor (T'10), the length of which is equal to said first length L and the width of which is equal to said second width v, and a second transistor (T'20), the length of which is equal to said second length 1 and the width of which is equal to said first width W.

**5.** The test structure according to claim 2, wherein n=3.

**6.** The test structure according to claim 5, wherein:

- the first device ($DT_1$) comprises a transistor (T100) with a first length 11 and a first width v1, a second transistor (T200) with a second length 12 and a second width W, and a third transistor with a third length L and a third width v2, where L>12>11 and W>v2>v 1;
- the second device ($DT_2$) comprises a first transistor (T'100), the length of which is equal to said second length 12 and the width of which is equal to said third width v2, a second transistor (T'200), the length of which is equal to said first length 11 and the width of which is equal to said second width W, and a third transistor (T'300), the length of which is equal to said third length L, and the width of which is equal to said first width v1.

**7.** The test structure according to any one of claims 1 to 6, comprising in each of said devices a first connection structure for connecting the first node (n1, n1') to a first test pad (p1, p1') and a second connection structure for connecting the second node (n2, n2') to a second test pad (p2, p2').

**8.** The test structure according to claim 7, wherein the first connection structures and the second connection structures, respectively, are identical for the two devices.

**9.** The test structure (ST) according to any one of claims 1 to 6, further comprising two identical CMOS inverters (INV1, INV2), each inverter charging a respective device from among the first ($DT_1$) and the second ($DT_2$) devices, the P

type transistors of the two inverters receiving a common control signal ($V_p$) and the N type transistors of the two inverters receiving a common control signal ($V_n$), said control signals of the P and N type transistors being of the non-overlapping type.

10. The test structure according to claim 9, **characterised in that** the two inverters are formed within the vicinity of each other, typically at a distance of less than 1,000 micrometres.

11. A method for implementing a test structure (ST) for recording a curve of capacitance difference ($C_{ST}(V)$) as a function of the voltage between a first ($DT_1$) and a second ($DT_2$) device of said test structure, each device comprising MOS transistors, the gates of which are all electrically connected together to a first node (n1), and the sources and drains are all electrically connected together to a second node (n2), the transistors of the two devices being of the same type, and the dimensions of the transistors being selected so that the sum of the lengths and the sum of the widths, respectively, are equal in the two devices, and that the difference in surface area $S_{equiv}$ between the two devices, provided by the equation $S_{equiv} = \Sigma(L_i . W_i) - \Sigma(L'_i . W'_i)$, is non-zero, where

- $L_i$, $W_i$ respectively designate the length and the width of a transistor $T_i$ of a first device $DT_1$ of the pair; and
- $L'_i$, $W'_i$ respectively designate the length and the width of a transistor $T'_i$ of a second device $DT_2$,
said method comprising determining capacitance as a function of the voltage applied to each of said first and second devices ($DT_1$, $DT_2$) and calculating the curve of capacitance difference between the two devices as a function of the voltage,converted to a curve of capacitance difference per unit of surface area, by dividing by said equivalent surface area $S_{equiv}$ of the test structure.

12. The method according to claim 11, each of said first and second devices comprising a first connection structure for connecting the first node (n1, n1') to a first test pad (p1, p1') and a second connection structure for connecting the second node (n2, n2') to a second test pad (p2, p2'), wherein the voltage is applied to the terminals of said first and second pads of each of said first and second devices by means of a capacitance meter.

13. The method according to claim 12, where said first connection structures and said second connection structures, respectively, are identical for the two devices.

14. The method according to claim 11, the test structure (ST) further comprising two identical CMOS inverters (INV1, INV2), each inverter charging a respective device from among the first ($DT_1$) and the second ($DT_2$) devices, the P type transistors of the two inverters receiving a common control signal ($V_p$) and the N type transistors of the two inverters receiving a common control signal ($V_n$), said control signals of the P and N type transistors being of the non-overlapping type, said method applying commutation control signals at a frequency f to said N and P type transistors of the inverters, providing a conduction time of the transistors P that is separate from the conduction time of the transistors N, and said method comprising the succession of the following measuring steps:

for each inverter and its associated charge device:

a) measuring the supply currents (11, 12) of each inverter, for a given commutation frequency (f) and a given supply voltage Vdd of the inverters, as a function of the conduction time ($t_p$) of the P type transistor, so as to obtain a first curve (Q11, Q12) providing the current quotient that is measured on frequency (11/f, 12/f) as a function of said conduction time,
b) extrapolating said first curve at source so as to obtain a current quotient value that is measured on the frequency extrapolated at source ($I1_0/f$, $I2_0/f$) corresponding to a conduction time of the zero transistor P,
c) repeating steps a) and b) for different supply voltage values (Vdd), allowing a second curve (F1, F2) to be obtained that provides the current quotient that is extrapolated at source on frequency ($I1_0/f$, $I2_0/f$), as a function of the supply voltage (Vdd),

then
calculating the curve of capacitance difference ($C_{ST}(V)$) per surface area unit between the two devices as a function of the voltage, comprising the following steps:

d) calculating the curve of difference ($\Delta Q$) between said second curves (F1, F2),
e) calculating the deviation of this curve of difference relative to the voltage ($\delta \Delta Q / \delta V$), and
f) dividing by said equivalent surface area $S_{equiv}$ of the test structure.

**15.** The method according to claim 14, wherein the two inverters of the test structure are formed within the vicinity of each other, typically at a distance of less than 1,000 micrometres.

**Patentansprüche**

**1.** Struktur zum Testen einer MOS-Kapazität (ST), die Folgendes umfasst: zwei Halbleiterbauelemente, ein erstes ($DT_1$) und ein zweites ($DT_2$), wobei jedes Bauelement MOS-Transistoren umfasst, deren Gates alle elektrisch mit einem ersten Knoten (n1) untereinander verbunden sind und deren Sources und Drains alle elektrisch mit einem zweiten Knoten (n2) untereinander verbunden sind, wobei die Transistoren der beiden Bauelemente vom selben Typ sind, **dadurch gekennzeichnet, dass** die Abmessungen der Transistoren so gewählt werden, dass die Summe der Längen bzw. die Summe der Breiten in den beiden Bauelementen gleich sind, und so, dass die Flächendifferenz ($S_{equiv}$) zwischen den beiden Bauelementen, ausgedrückt durch die Gleichung:

$$S_{equiv} = \Sigma(L_i . W_i) - \Sigma(L'_i . W'_i),$$

ungleich null ist, wobei

- $L_i$, $W_i$ jeweils die Länge und die Breite eines Transistors $T_i$ eines ersten Bauelementes $DT_1$ des Paares bedeuten; und
- $L'_i$, $W'_i$ jeweils die Länge und die Breite eines Transistors $T'_i$ eines zweiten Bauelementes $DT_2$ bezeichnen.

**2.** Teststruktur nach Anspruch 1, bei der die beiden Bauelemente dieselbe Anzahl n von MOS-Transistoren umfassen.

**3.** Teststruktur nach Anspruch 2, wobei n=2 ist.

**4.** Teststruktur nach Anspruch 3, wobei:

- das erste Bauelement ($DT_1$) einen ersten Transistor (T10) mit einer ersten Länge L und einer ersten Breite W und einen zweiten Transistor (T20) mit einer zweiten Länge 1 und einer zweiten Breite v umfasst, wobei L>1 und W>v ist;
- das zweite Bauelement ($DT_2$) einen ersten Transistor (T'10), dessen Länge gleich der genannten ersten Länge L ist und dessen Breite gleich der genannten zweiten Breite v ist, und einen zweiten Transistor (T'20) umfasst, dessen Länge gleich der genannten zweiten Länge 1 und dessen Breite gleich der genannten ersten Breite W ist.

**5.** Teststruktur nach Anspruch 2, wobei n=3 ist.

**6.** Teststruktur nach Anspruch 5, wobei:

- das erste Bauelement ($DT_1$) einen Transistor (T100) mit einer ersten Länge 11 und einer ersten Breite v1, einen zweiten Transistor (T200) mit einer zweiten Länge 12 und einer zweiten Breite W und einen dritten Transistor mit einer dritten Länge L und einer dritten Breite v2 umfasst, wobei L>12>11 und W>v2>vlist;
- das zweite Bauelement ($DT_2$) einen ersten Transistor (T'100), dessen Länge gleich der zweiten Länge 12 und dessen Breite gleich der dritten Breite v2 ist, einen zweiten Transistor (T'200), dessen Länge gleich der erste Länge 11 und dessen Breite gleich der zweiten Breite W ist, und einen dritten Transistor (T'300) umfasst, dessen Länge gleich der dritten Länge L ist und dessen Breite gleich der ersten Breite v1 ist.

**7.** Teststruktur nach einem der Ansprüche 1 bis 6, die in jedem der Bauelemente eine erste Verbindungsstruktur zum Verbinden des ersten Knotens (n1, n1') mit einem ersten Testkontakt (p1, p1') und eine zweite Verbindungsstruktur zum Verbinden des zweiten Knotens (n2, n2') mit einem zweiten Testkontakt (p2, p2') hat.

**8.** Teststruktur nach Anspruch 7, wobei die ersten Verbindungsstrukturen bzw. die zweiten Verbindungsstrukturen für die beiden Bauelemente identisch sind.

**9.** Teststruktur (ST) nach einem der Ansprüche 1 bis 6, die darüber hinaus zwei identische CMOS-Inverter (INV1, INV2) umfasst, wobei jeder Inverter ein jeweiliges Bauelement aus dem ersten ($DT_1$) und dem zweiten ($DT_2$) Bau-

element lädt, wobei die Transistoren des Typs P der beiden Inverter ein gemeinsames Steuersignal ($V_p$) empfangen und die Transistoren des Typs N der beiden Inverter ein gemeinsames Steuersignal ($V_n$) empfangen, wobei die Steuersignale der Transistoren P und N vom nicht überlappenden Typ sind.

10. Teststruktur nach Anspruch 9, **dadurch gekennzeichnet, dass** die beiden Inverter nahe beieinander, typischerweise in einem Abstand von weniger als 1000 Mikrometer, realisiert sind.

11. Verfahren zum Ausführen einer Teststruktur (ST) zum Aufzeichnen einer Kapazitätsdifferenzkurve ($C_{ST}(V)$) in Abhängigkeit von der Spannung zwischen einem ersten ($DT_1$) und einem zweiten ($DT_2$) Bauelement der Teststruktur, wobei jedes Bauelement MOS-Transistoren umfasst, deren Gates elektrisch mit einem ersten Knoten (n1) untereinander verbunden sind und deren Sources und Drains alle elektrisch mit einem zweiten Knoten (n2) untereinander verbunden sind, wobei die Transistoren der beiden Bauelemente vom selben Typ sind und wobei die Dimensionen der Transistoren so gewählt werden, dass die Summe der Längen bzw. die Summe der Breiten in den beiden Bauelementen gleich sind und die Flächendifferenz $S_{equiv}$ zwischen den beiden Bauelementen, ausgedrückt durch die Gleichung

$$S_{equiv} = \Sigma(L_i . W_i) - \Sigma(L'_i . W'_i),$$

ungleich null ist, wobei

- $L_i$, $W_i$ jeweils die Länge und die Breite eines Transistors $T_i$ eines ersten Bauelements $DT_1$ des Paares bezeichnen; und
- $L'_i$, $W'_i$ jeweils die Länge und die Breite eines Transistors $T'_i$ eines zweiten Bauelementes $DT_2$ bezeichnen, wobei das Verfahren das Ermitteln der Kapazität in Abhängigkeit von der Spannung, die an jedes der ersten und zweiten Bauelemente ($DT_1$, $DT_2$) angelegt wird, und das Berechnen der Kapazitätsdifferenzkurve zwischen den beiden Bauelementen in Abhängigkeit von der Spannung, konvertiert in eine Differenzkapazitätskurve pro Flächeneinheit, durch Dividieren durch die äquivalente Fläche $S_{equiv}$ der Teststruktur beinhaltet.

12. Verfahren nach Anspruch 11, wobei jedes erste und zweite Bauelement eine erste Verbindungsstruktur zum Verbinden des ersten Knotens (n1, n1') mit einem ersten Testkontakt (p1, p1') und eine zweite Verbindungsstruktur zum Verbinden des zweiten Knotens (n2, n2') mit einem zweiten Testkontakt (p2, p2') umfasst, wobei die Spannung an die Anschlüsse des ersten und zweiten Kontakts jedes ersten und zweiten Bauelements mittels eines Kapazitätsanessers angelegt wird.

13. Verfahren nach Anspruch 12, wobei die ersten Verbindungsstrukturen bzw. die zweiten Verbindungsstrukturen für die beiden Bauelemente identisch sind.

14. Verfahren nach Anspruch 11, wobei die Teststruktur (ST) darüber hinaus zwei identische CMOS-Inverter (INV1, INV2) umfasst, wobei jeder Inverter ein jeweiliges Bauelement aus dem ersten ($DT_1$) und dem zweiten ($DT_2$) Bauelement lädt, wobei die Transistoren des Typs P der beiden Inverter ein gemeinsames Steuersignal ($V_p$) empfangen, und die Transistoren des Typs N der beiden Inverter ein gemeinsames Steuersignal ($V_n$) empfangen, wobei die Steuersignale der Transistoren P und N vom nicht überlappenden Typ sind, wobei das Verfahren die Kommutationssteuersignale mit einer Frequenz f an die Transistoren des Typs N und P der Inverter anlegt, und dabei eine Leitungszeit der Transistoren P separat von einer Leitungszeit der Transistoren N erzielt, und wobei das Verfahren die Folge der folgenden Messschritte beinhaltet:

für jeden Inverter und sein assoziiertes Ladebauelement:

a) Messen der Speiseströme (11, 12) jedes Inverters für eine gegebene Kommutationsfrequenz (f) und eine gegebene Speisespannung Vdd der Inverter in Abhängigkeit von der Leitungszeit ($t_p$) des Transistors des Typs P, um eine erste Kurve (Q11, Q12) zu erhalten, die den auf der Frequenz (11/f, 12/f) gemessenen Stromquotienten ergibt, in Abhängigkeit von der Leitungszeit,
b) Extrapolieren der ersten Kurve am Ursprung, um einen Wert des auf der Frequenz gemessenen Stromquotienten zu erhalten, extrapoliert am Ursprung ($I1_0/f$, $I2_0/f$), der einer Leitungszeit des Null-Transistors P entspricht,
c) Wiederholen der Schritte a) und b) für verschiedene Speisespannungsweite (Vdd), so dass eine zweite Kurve (F1, F2) erhalten werden kann, die den Stromquotienten ergibt, extrapoliert am Ursprung auf der Frequenz ($I1_0/f$, $I2_0/f$) in Abhängigkeit von der Speisespannung (Vdd), dann

Berechnen der Kapazitätsdifferenzkurve ($C_{ST}(V)$) pro Flächeneinheit zwischen den beiden Bauelementen in Abhängigkeit von der Spannung, umfassend die folgenden Schritte:

d) Berechnen der Differenzkurve ($\Delta Q$) zwischen den zweiten Kurven (F1, F2),
e) Berechnen der Abweichung dieser Differenzkurve in Bezug auf die Spannung ($\delta\Delta Q/\delta V$), und
f) Dividieren der Teststruktur durch die äquivalente Fläche $S_{equiv}$.

**15.** Verfahren nach Anspruch 14, bei dem die beiden Inverter der Teststruktur nahe beieinander, typischerweise in einem Abstand von weniger als 1000 Mikrometer, realisiert werden.

FIG.1

FIG.2

FIG.3

EP 2 104 143 B1

FIG.4

FIG.5a

FIG.5b

FIG.6

EP 2 104 143 B1

**FIG.7b**

$DT_1 \{(L_1, W_1)\ldots(L_i, W_i))\ldots(L_n, W_n)\}$

$DT_2 \{(L'_1, W'_1)\ldots(L'_i, W'_i))\ldots(L'_n, W'_n)\}$

$C(V)$

30, 30A, 30B, p1, n1, n2, p2, p'1, n'1, n'2, p'2

**FIG.7a**

a — Mesure $C_1(V)$ de $DT_1$ - Mesure $C_2(V)$ de $DT_2$

b — Calcul $C_{ST}(V) = [C_1(V) - C_2(V)] / S_{equiv}$

FIG.8

FIG.9

EP 2 104 143 B1

FIG.10a

FIG.10b

FIG.10c

FIG.10d

EP 2 104 143 B1

FIG.11

FIG.12

EP 2 104 143 B1

FIG.13

I1/f, I2/f à f et $V_{dd}$ donnés

H1

H2

$I1_0/f$

$I2_0/f$

0

$t_p$

FIG.14

mesures  calculs

Mesure I2, à $V_{dd}$, f et tp donnés

Calcul I2/f

Variation de tp

Courbe H2 donnant I2/f en fonction de tp

Détermination de $I2_0/f$ à tp nul

Courbe F2 donnant $I2_0/f$ en fonction de $V_{dd}$

Etape c).

Variation de $V_{dd}$

Etape d).

$\Delta Q = F1 - F2$

$\delta/\delta v$

Etape e).

$/S_{equiv}$

Etape f).

$C_{ST}$

Mesure I1, à $V_{dd}$, f et tp donnés

Calcul I1/f

Courbe H1 donnant I1/f en fonction de tp

Détermination de $I1_0/f$ à tp nul

Courbe F1 donnant $I1_0/f$ en fonction de $V_{dd}$

Etape a).

Etape b).

FIG.15

## RÉFÉRENCES CITÉES DANS LA DESCRIPTION

**Documents brevets cités dans la description**

- US 7069525 B
- US 2005090916 A

- US 6870375 B


**Littérature non-brevet citée dans la description**

- **C. Leroux et al.** Characterization and modeling of nanometric SiO2 dielectrics. *Microelectronic Engineering,* Avril 2004, vol. 72 (1-4), 121-124

- **B. W. McGaughy ; J.C. Chen ; D. Sylvester ; C. Hu.** A Simple Method for On-Chip Sub-Femto Farad Interconnect Capacitance Measurement. *IEEE Electron Device Letters,* Janvier 1997, vol. 18 (1), 21-23